# EUROPEAN PATENT APPLICATION

(11) **EP 4 651 655 A1**
(43) Date of publication of application: **19.11.2025**
(21) Application number: 24214127.3
(22) Date of filing: 20.11.2024
(51) Int. Cl.: H05K 7/20

(54) **LIQUID COOLING SERVER CABINET, AND SINGLE-NODE IMMERSED SERVER SYSTEM**

(30) Priority: 15.05.2024 CN 202410607330
(71) Applicant: Inventec (Pudong) Technology Corporation, Shanghai (CN); Inventec Corporation, Taipei City (TW)
(72) Inventor: Wu, Jiang-jun, Shanghai (CN); Zhu, Kangguang, Shanghai City (CN); Ji, Yi-dong, Shanghai (CN); Chen, Xuefeng, Shanghai City (CN); Xiang, Pin-Yi, Shanghai City (CN); Zeng, Boheng, Shanghai (CN); Lu, Xiaogang, Shanghai City (CN); Xu, Ji-Peng, Shanghai City (CN)
(74) Representative: Dompatent

(57) **Abstract**

The present disclosure relates to a liquid cooling server cabinet (12), including a cabinet body (100), a liquid cooling module (200), and a pluggable assembly (300). The cabinet body (100) is provided with a receiving cavity, and the pluggable assembly (300) is arranged in the receiving cavity. The pluggable assembly (300) includes at least one pluggable portion (310). The liquid cooling module (200) includes at least one liquid cooling unit (200a) corresponding to the at least one pluggable portion (310). The pluggable portion (310) is configured for a plugging and mounting of a single-node server (11) that defines a cooling cavity. When the pluggable portion (310) is mounted with the single-node server (11), the liquid cooling unit (200a) is communicated with the cooling cavity of the corresponding single-node server (11).

## Description

### CROSS-REFERENCE TO RELATED DISCLOSURES

This application claims priority to Chinese patent application No. 2024106073300 filed with the Chinese Patent Office on May 15, 2024, entitled "LIQUID COOLING SERVER CABINET, AND SINGLE-NODE IMMERSED SERVER SYSTEM", the entire content of which is incorporated by reference.

### TECHNICAL FIELD

The present disclosure relates to the technical field of server heat dissipation, and in particular, to a liquid cooling server cabinet, and a single-node immersed server system.

### BACKGROUND

With the rapid development of data center technology, requirements for thermal management of servers in data centers are becoming increasingly higher, so a fully immersed liquid cooling technology has emerged. The fully immersed liquid cooling technology generally uses medium to large horizontal cabinets to immerse respective node servers in the cabinets filled with cooling liquid, and the respective node servers need to be maintained regularly.

In related art, for the respective node servers in the medium to large horizontal cabinet, professional lifting tools are generally required to lift the respective node servers from the cabinet and drain them during maintenance, which is difficult to operate and time-consuming, resulting in high operation and maintenance costs.

### SUMMARY

In one aspect, the present disclosure provides a liquid cooling server cabinet, including a cabinet body, a liquid cooling module, and a pluggable assembly. The cabinet body is provided with a receiving cavity, and the pluggable assembly is arranged in the receiving cavity. The pluggable assembly includes at least one pluggable portion. The liquid cooling module includes at least one liquid cooling unit corresponding to the at least one pluggable portion. The at least one pluggable portion is configured for a plugging and mounting of a single-node server that defines a cooling cavity, and the at least one liquid cooling unit is configured to communicate with the cooling cavity of the corresponding single-node server when the single-node server is mounted in the at least one pluggable portion.

In an embodiment, the pluggable assembly further includes a carrier plate. The carrier plate is attached to an inner wall of the cabinet body. The at least one pluggable portion is arranged on a surface of the carrier plate.

In an embodiment, the pluggable portion includes a guide rail and a locking mechanism. The locking mechanism is arranged at an end of the guide rail.

In an embodiment, the liquid cooling module includes a liquid inlet module and a liquid outlet module. The liquid inlet module includes at least one liquid inlet unit corresponding to the at least one pluggable portion, and the liquid outlet module includes at least one liquid outlet unit corresponding to the at least one pluggable portion.

In an embodiment, there are multiple liquid inlet units and multiple liquid outlet units, and a number of the liquid inlet units is equal to a number of the liquid outlet units.

In an embodiment, the liquid inlet module further includes a first manifold and a liquid inlet pipe. The liquid inlet units are arranged on the first manifold at equal intervals and communicated with each other via the first manifold, and the first manifold is communicated with the liquid inlet pipe. The liquid outlet module further includes a second manifold and a liquid outlet pipe. The liquid outlet units are arranged on the second manifold at equal intervals and communicated with each other via the second manifold, and the second manifold is communicated with the liquid outlet pipe.

In an embodiment, the first manifold and the second manifold are arranged parallel to each other at a preset spacing.

In an embodiment, the liquid cooling server cabinet further includes a busbar and a wire module. The busbar is electrically connected to the wire module, and the busbar is configured to electrically connect to the single-node server plugged and mounted in the at least one pluggable portion.

In another aspect, the present disclosure further provides a single-node immersed server system, including the above liquid cooling server cabinet. The single-node immersed server system further includes at least one single-node server. The single-node server is capable of being plugged and mounted in the at least one pluggable portion. The single-node server defines a cooling cavity, and when the single-node server is plugged into the at least one pluggable portion, the cooling cavity of the single-node server is communicated with the corresponding liquid cooling unit.

In an embodiment, the single-node server is provided with a cooling liquid inlet and an outlet, and the cooling liquid inlet and outlet are capable of being plugged and matched with the corresponding liquid cooling unit.

In an embodiment, the single-node server is further provided with a power connector. When the single-node server is plugged into the pluggable portion, the power connector is electrically connected to the liquid cooling server cabinet.

### BRIEF DESCRIPTION OF THE DRAWINGS

In order to illustrate the technical solutions in the embodiments of the present disclosure or prior art more clearly, the accompanying drawings used in the description of the embodiments or prior art will be briefly introduced below. Apparently, the accompanying drawings in the following description are only some embodiments of the present disclosure. For those of ordinary skill in the art, other drawings can also be derived from these drawings without creative effort.
FIG. 1 is a schematic diagram illustrating a configuration of a single-node immersed server system according to an embodiment of the present disclosure.
FIG. 2 is a schematic diagram illustrating a configuration of the single-node immersed server system shown in FIG. 1 from another perspective.
FIG. 3 is a schematic diagram illustrating an enlarged detail of the single-node immersed server system shown in FIG. 1 at point A.
FIG. 4 is a schematic diagram illustrating a configuration of a liquid cooling module in the single-node immersed server system shown in FIG. 2.
FIG. 5 is a schematic diagram illustrating a configuration of a single-node server in the single-node immersed server system shown in FIG. 1 according to another embodiment.

### DETAILED DESCRIPTION OF THE EMBODIMENTS

In order to make the above objectives, features and advantages of the present disclosure more obvious and understandable, specific implementations of the present disclosure are described in detail below with reference to the accompanying drawings. In the following description, many specific details are set forth in order to fully understand the present disclosure. However, the present disclosure can be implemented in many other ways different from those described herein, and those skilled in the art can make similar improvements without departing from the connotation of the present disclosure. Therefore, the present disclosure is not limited by the specific embodiments disclosed below.

In the description of the present disclosure, it should be understood that if the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are used, these terms indicate the orientation or position relationship as shown in the accompanying drawings and are merely intended to facilitate the description of the present disclosure and simplify the description, rather than indicating or implying that the indicated device or element must have a specific orientation or be constructed and operated in a specific orientation. Therefore, these terms are not to be interpreted as limiting the present disclosure.

In addition, if the terms such as "first" and "second" are used, they are used for descriptive purposes only, and should not be understood as indicating or implying relative importance or implicitly indicating the quantity of the technical features indicated. Thus, the features described with "first" and "second", etc., may explicitly or implicitly include at least one of these features. In the description of the present disclosure, if the term "multiple" is used, it means at least two, such as two, three, etc., unless otherwise clearly and specifically defined.

In the present disclosure, unless otherwise clearly specified and limited, the terms "mounted", "coupling", "connection", "fixation", etc., should be understood in a broad sense, for example, it may be a fixed connection, a detachable connection, or integration. It may be a mechanical connection or an electrical connection. It may be a direct connection or an indirect connection through an intermediate medium. It may be an internal connection between two elements or an interaction relationship between the two elements, unless otherwise clearly defined. Those of ordinary skill in the art can understand the specific meanings of the above terms in the present disclosure according to specific situations.

In the present disclosure, unless otherwise clearly specified and limited, if there is a description that a first feature is "on" or "under" a second feature, etc., it may mean that the first and second features are in direct contact, or the first and second features are in indirect contact through an intermediate medium. Moreover, the first feature being "on", "above", or "over" the second feature may mean that the first feature is directly above or obliquely above the second feature, or simply means that the horizontal height of the first feature is greater than that of the second feature. The first feature being "under", "beneath" and "below" the second feature may mean that the first feature is directly below or obliquely below the second feature, or simply means that the horizontal height of the first feature is less than that of the second feature.

It should be noted that when an element is referred to as being "fixed on" or "disposed on" another element, it may be directly on the other element or there may be an intervening element. When an element is referred to as being "connected to" another element, it may be directly connected to the other element or there may also be an intermedium elements. If present, the terms "vertical", "horizontal", "upper", "lower", "left", "right" and similar expressions used in this disclosure are for the purpose of illustration only and are not meant to be the only implementation methods.

In conventional technology, node servers are generally cooled using a fully immersed liquid cooling technology. The fully immersed liquid cooling technology generally uses medium to large horizontal cabinets to immerse node servers in the cabinets filled with cooling liquid. It should be noted that the opening of the medium or large horizontal cabinet is arranged to face upward, and node slots for mounting the respective node servers are defined in the horizontal cabinet.

The above-mentioned fully immersed liquid cooling technology using the medium to large horizontal cabinets has at least the following shortcomings.

Firstly, the cooling liquid consumption is excessive. Since the respective node servers need to be fully immersed in the horizontal cabinet, a cavity of the horizontal cabinet needs to be filled with cooling liquid, resulting in excessive consumption of cooling liquid.

Secondly, the immersion effect is poor. Theoretically, when all the node slots of the horizontal cabinet are occupied by the node servers, the cooling liquid in the cavity of the horizontal cabinet reaches a preset amount that is sufficient to completely immerse the node servers. However, when some of the node slots of the horizontal cabinet are unoccupied by the node servers, the level of the cooling liquid in the cavity of the horizontal cabinet will be lower than that when all the node slots are occupied by the node servers, resulting in a reduced immersion effect and cooling effect for each node server.

Thirdly, the operation is cumbersome. In the case that the cooling liquid level in the cavity of the horizontal cabinet drops when not all the node slots of the horizontal cabinet are occupied by the node servers, in conventional technology, a "placeholder block" is generally used to ensure that the cooling liquid level is maintained at a normal height. However, this operation is cumbersome and requires frequent installation and removal of placeholder blocks. It should be noted that the above-mentioned "placeholder block" may be a block of the same volume as the node server, and may be adaptively mounted in an empty node slot in the horizontal cabinet.

Fourthly, operation and maintenance are arduous and costly. During the subsequent operation and maintenance process, if any one or more of the node servers need to be repaired, the entire horizontal cabinet needs to be moved for repair, causing the service center to stop operating. During the maintenance process, the node server to be repaired needs to be lifted and drained. The draining process is time-consuming, and the cooling liquid drips and splashes during the draining process. The cooling liquid is easy to evaporate during the opening process, resulting in a waste of resources. During the process of lifting the node server, multiple people are needed to control the overhead crane and support the node server to prevent it from shaking, which consumes a lot of manpower. Therefore, the operation and maintenance of the fully immersed liquid cooling technology are arduous and costly.

In order to solve the above technical problems, the present disclosure provides a liquid cooling server cabinet 12, and a single-node immersed server system 10.

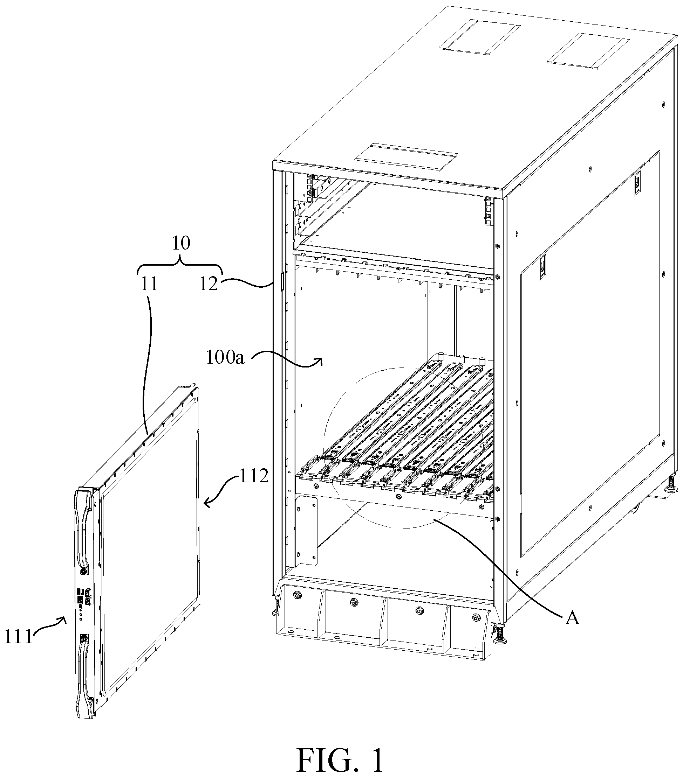

FIG. 1 is a schematic diagram illustrating a configuration of a single-node immersed server system 10 according to an embodiment of the present disclosure. The single-node immersed server system 10 includes a single-node server 11 and a liquid cooling server cabinet 12. The single-node server 11 is mounted in the liquid cooling server cabinet 12, and a cooling cavity is defined in the chassis of the single-node server 11.

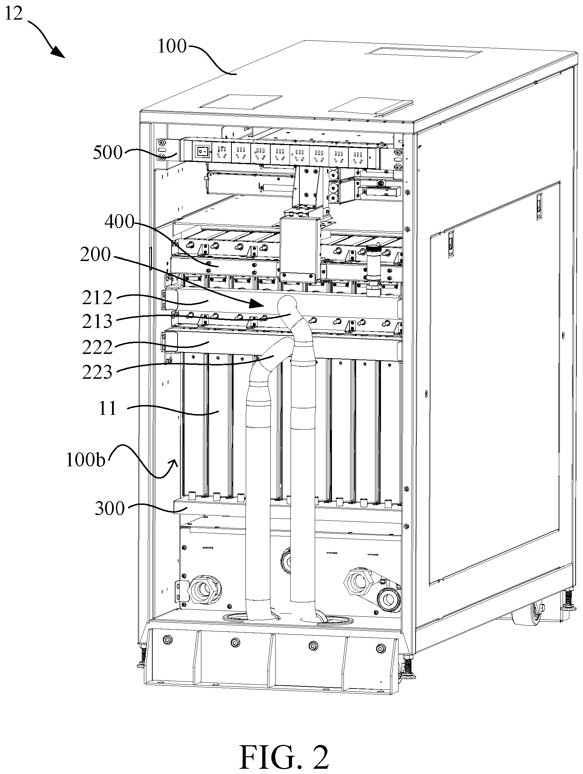

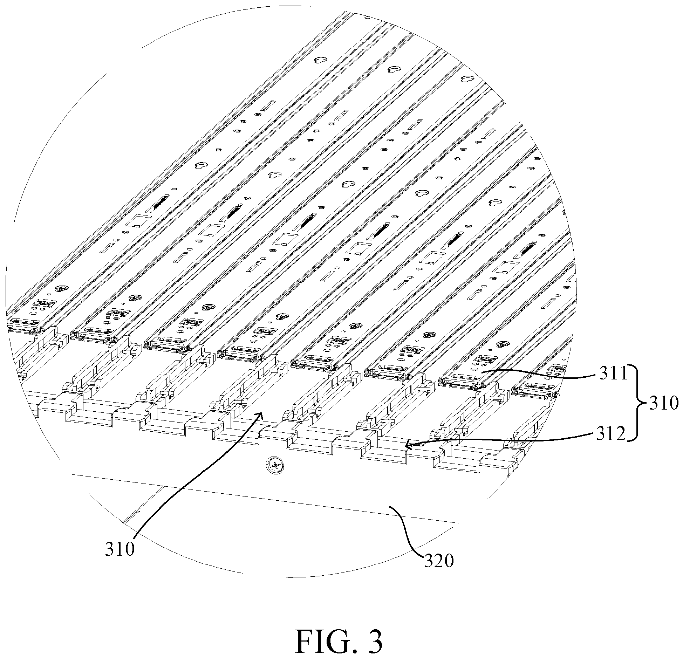

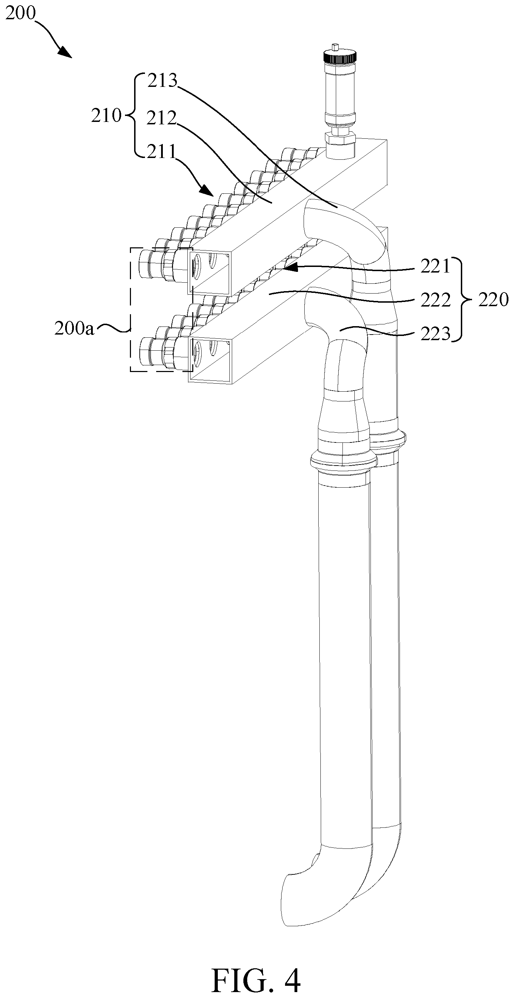

With reference to FIGS. 2 to 4, FIG. 2 is a schematic diagram illustrating a configuration of the single-node immersed server system 10 shown in FIG. 1 from another perspective, FIG. 3 is a schematic diagram illustrating an enlarged detail of the single-node immersed server system 10 shown in FIG. 1 at point A, and FIG. 4 is a schematic diagram illustrating a configuration of a liquid cooling module 200 in the single-node immersed server system 10 shown in FIG. 2.

The liquid cooling server cabinet 12 according to an embodiment of the present disclosure includes a cabinet body 100, a liquid cooling module 200, and a pluggable assembly 300. The cabinet body 100 is provided with a receiving cavity having a first opening 100a and a second opening 100b. The pluggable assembly 300 is arranged in the receiving cavity. The pluggable assembly 300 includes at least two pluggable portions 310. The pluggable portions 310 extend in a direction from the first opening 100a to the second opening 100b, and the respective pluggable portions 310 are arranged in parallel with each other. The liquid cooling module 200 includes liquid cooling units 200a respectively corresponding to the pluggable portions 310. Each of the pluggable portions 310 is configured for the plugging and mounting of a single-node server 11 that defines a cooling cavity. The single-node server 11 includes a handle end 111 and a power supply end 112. When the pluggable portion 310 is mounted with the single-node server 11, the handle end 111 faces the first opening 100a, the power supply end 112 faces the second opening 100b, and the liquid cooling unit 200a is communicated with the cooling cavity of the corresponding single-node server 11.

It can be understood that the number of the pluggable portion is not limited in the present disclosure.

The above liquid cooling server cabinet 12 is provided with the pluggable portions 310, achieving an installation mode in which the single-node server 11 is plugged into or out of one of the pluggable portions 310. This mode is easy to operate, improving the convenience of installation and removal for the single-node server 11, and reducing the operation and maintenance costs. In addition, the liquid cooling server cabinet 12 of the present disclosure is further provided with the liquid cooling units 200a corresponding to the pluggable portions 310, respectively, so as to facilitate achieving one-to-one automatic connection and automatic liquid supply for the single-node server 11. Further, the single-node server 11 does not need to be immersed in a cabinet fully filled with cooling liquid while meeting the heat dissipation requirement of the single-node server 11, thereby reducing the draining process in the subsequent operation and maintenance process, and facilitating reducing the operation and maintenance costs.

Furthermore, the liquid cooling server cabinet 12 provided in the present disclosure is suitable for a single-node server 11 that is cooled by means of the cooling cavity inside the chassis thereof. Compared with the fully immersed liquid cooling technology, this cooling method achieves independent cooling for a single node without filling the receiving cavity of the liquid cooling server cabinet 12 with cooling liquid. Therefore, the overall consumption of the cooling liquid in the liquid cooling server cabinet 12 is significantly reduced, greatly reducing the demand for the cooling liquid and cost expenditure.

Furthermore, since this cooling method is performed by using the cooling cavity inside the chassis of the single-node server 11 without filling the receiving cavity of the liquid cooling server cabinet 12 with cooling liquid, the operation of draining the cooling liquid on the single-node server in the subsequent operation and maintenance process is excluded, thereby avoiding losses such as liquid splashing and evaporation, which facilitates to improve the operation and maintenance efficiency and reduce the operation and maintenance costs.

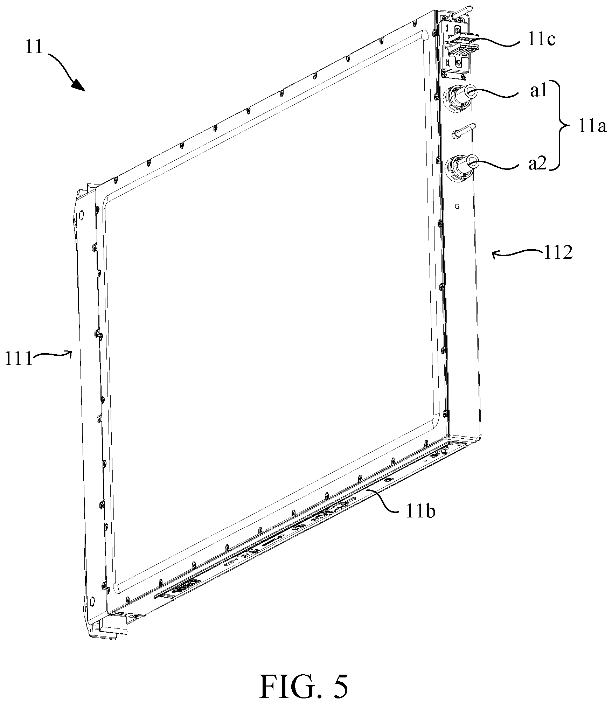

Specifically, with reference to FIG. 5, in some embodiments, the single-node server 11 is provided with a cooling liquid inlet and outlet 11a. The liquid cooling unit 200a of the liquid cooling server cabinet 12 provided in the present disclosure can be communicated with the cooling liquid inlet and outlet 11a, and circulate the cooling liquid into the cooling cavity in the chassis of the single-node server 11 to achieve cooling. The cooling operation of the respective single-node servers 11 is independent of each other.

Regardless of whether all the pluggable portions 310 of the liquid cooling server cabinet 12 are loaded with single-node servers 11, the cooling effect of the respective single-node servers 11 will not be affected. Therefore, the liquid cooling server cabinet 12 provided in the present disclosure does not need to be provided with the above "placeholder block", so that the operation is simple and reliable.

In addition, if any one or more of the single-node servers 11 need to be repaired, it is only necessary to unplug the single-node server 11 to be repaired from the corresponding pluggable portion 310 for maintenance, which will not affect the operation of other single-node servers 11. Therefore, there is no need to shut down the entire liquid cooling server cabinet 12, thereby ensuring that the daily operation of the liquid cooling server cabinet 12 is not affected. Moreover, compared with the traditional method of using a crane to lift the single-node server 11, the plug-in and unplug operation for the single-node server 11 is more convenient, which facilitates to improve the operation and maintenance efficiency.

With reference to FIGS. 1 to 3, in some embodiments, the pluggable assembly 300 further includes a carrier plate 320. The carrier plate is attached to an inner wall of the cabinet body 100, and the carrier plate 320 and a bottom wall of the cabinet body 100 are parallel to each other. The pluggable portions 310 are arranged on a surface of the carrier plate 320.

In some embodiments, the pluggable portion 310 may be a slot with a baffle, and the single-node server 11 can be plugged into the slot. The carrier plate 320 is configured to carry the single-node server 11.

With reference to FIG. 3, in some embodiments, each of the pluggable portions 310 includes a guide rail 311 and a locking mechanism 312. The locking mechanism 312 is arranged at an end of the guide rail 311 close to the first opening 100a. The single-node server 11 can slidingly cooperate with the guide rail 311, and can be plugged and unplugged along the slide rail. The locking mechanism 312 is configured to position the single-node server 11, so as to ensure that the single-node server 11 is plugged in and out in place.

Understandably, with reference to FIG. 5, in some embodiments, the single-node server 11 is provided with a slide bar 11b. The slide bar 11b is configured to slidingly cooperate with the guide rail 311 of the pluggable portion 310, so as to improve the smoothness of plugging and unplugging of the single-node server 11.

As shown in FIG. 4, in some embodiments, the liquid cooling module 200 includes a liquid inlet module 210 and a liquid outlet module 220. The liquid inlet module 210 includes liquid inlet units 211 corresponding to the pluggable portions 310, respectively. The liquid outlet module 220 includes liquid outlet units 221 corresponding to the pluggable portions 310, respectively.

Specifically, as shown in FIG. 5, the single-node server 11 is provided with a cooling liquid inlet and outlet 11a. The cooling liquid inlet and outlet 11a is defined on a side of the chassis of the single-node server 11. The cooling cavity is defined in the chassis of the single-node server 11. The cooling liquid inlet and outlet 11a includes a liquid inlet a1 and a liquid outlet a2. The liquid inlet unit 211 is configured to communicate with the liquid inlet a1, and the liquid outlet unit 221 is configured to communicate with the liquid outlet a2. The liquid inlet unit 211 is configured to introduce cooling liquid into the cooling cavity inside the chassis of the single-node server 11. The cooling liquid is injected into the cooling cavity inside the chassis of the single-node server 11 and finally flows out to the liquid outlet unit 221 through the liquid outlet a2, thereby taking away the heat of the single-node server 11 during operation, thus realizing the circulation cooling process of the cooling liquid.

More specifically, as shown in FIG. 4, the number of the liquid inlet units 211 of the liquid inlet module 210 is equal to the number of the liquid outlet units 221 of the liquid outlet module 220, and each pair of liquid inlet unit 211 and liquid outlet unit 221 acts as one liquid cooling unit 200a. The liquid cooling unit 200a is communicated with the cooling liquid inlet and outlet 11a of the corresponding single-node server 11. The circulation processes of the cooling liquid of the respective liquid cooling units 200a do not affect each other, in other words, each liquid cooling unit 200a is applied to the single-node server 11 located at the corresponding pluggable portion 310.

With continued reference to FIG. 4, in some embodiments, the liquid inlet module 210 further includes a first manifold 212 and a liquid inlet pipe 213. The respective liquid inlet units 211 are arranged on the first manifold 212 at equal intervals and communicated with each other via the first manifold 212, and the first manifold 212 is communicated with the liquid inlet pipe 213. The liquid outlet module 220 further includes a second manifold 222 and a liquid outlet pipe 223. The respective liquid outlet units 221 are arranged on the second manifold 222 at equal intervals and communicated with each other via the second manifold 222, and the second manifold 222 is communicated with the liquid outlet pipe 223.

Specifically, by arranging the respective liquid inlet units 211 on the first manifold 212 at equal intervals and arranging the respective liquid outlet units 221 on the second manifold 222 at equal intervals, it facilitates improving the structural compactness and integration of both the liquid inlet module 210 and the liquid outlet module 220. It should be understood that the cooling liquid can be divided in the first manifold 212 and the second manifold 222 to flow into or out of the corresponding liquid cooling unit 200a.

In some embodiments, the first manifold 212 and the second manifold 222 are arranged parallel to each other at a preset spacing. This arrangement allows the cooling liquid inlet and outlet 11a of the single-node server 11 to automatically align with the first manifold 212 and the second manifold 222, respectively, and communicate with the corresponding liquid inlet unit 211 and the corresponding liquid outlet unit 221 after the single-node server 11 is plugged into the pluggable portion 310. It should be understood that the spacing between the liquid inlet a1 and the liquid outlet a2 of the single-node server 11 is equal to the above preset spacing, thereby ensuring the precise positioning between the liquid inlet a1 and the liquid inlet unit 211, and the precise positioning between the liquid outlet a2 and the liquid outlet unit 221.

With reference to FIG. 1 and FIG. 5, in an embodiment, the present disclosure further provides a single-node immersed server system 10, including the liquid cooling server cabinet 12 in any one of the above embodiments. The single-node immersed server system 10 further includes at least one single-node server 11. The single-node server 11 can be selectively plugged and mounted in one of the pluggable portions 310. The single-node server 11 defines a cooling cavity. When the single-node server 11 is plugged into any one of the pluggable portions 310, the cooling cavity of the single-node server 11 is communicated with the corresponding liquid cooling component 200a.

For the above single-node immersed server system 10, by setting the pluggable portions 310 of the liquid cooling server cabinet 12, an installation mode in which the single-node server 11 is plugged into or out of one of the pluggable portions 310 is achieved. This mode is easy to operate, which facilitates improving the convenience of installation and removal for the single-node server 11 in the single-node immersed server system 10, reducing the operation and maintenance costs. In addition, the liquid cooling server cabinet 12 is further provided with liquid cooling units 200a corresponding to the pluggable portions 310, respectively, so as to facilitate achieving one-to-one automatic connection and automatic liquid supply for the single-node server 11. Further, the single-node server 11 does not need to be immersed in a cabinet fully filled with cooling liquid while meeting the heat dissipation requirement of the single-node server 11, thereby reducing the draining process in the subsequent operation and maintenance process, and facilitating reducing the operation and maintenance costs.

As shown in FIG. 5, the single-node server 11 of the single-node immersed server system 10 is provided with a cooling liquid inlet and outlet 11a. The cooling liquid inlet and outlet 11a is capable of being plugged and matched with the corresponding liquid cooling unit 200a. Specifically, when the single-node server 11 is plugged into any one of the pluggable portions 310, the cooling liquid inlet and outlet 11a is communicated with the corresponding liquid cooling unit 200a, so that the liquid cooling unit 200a can introduce cooling liquid into the cooling cavity, and the cooling liquid circulates out from the cooling liquid inlet and outlet 11a, thereby taking away the heat of the single-node server 11 during operation.

In some embodiments, the single-node server 11 is further provided with a power connector 11c. When the single-node server 11 is plugged into any one of the pluggable portions 310, the power connector 11c is electrically connected to a busbar 400 of the liquid cooling server cabinet 12, so that the liquid cooling server cabinet 12 automatically supplies power to the single-node server 11. Further, when the single-node server 11 is plugged out of the pluggable portion 310, the liquid cooling server cabinet 12 is automatically powered off.

With reference to FIG. 2, in some embodiments, the liquid cooling server cabinet 12 further includes a busbar 400 and a wire module 500. The busbar 400 is electrically connected to the wire module 500, and the busbar 400 is configured to electrically connect to the single-node server 11 plugged and mounted in any one of the pluggable portions 310. Specifically, the wire module 500 is configured to connect to an external power supply. When the single-node server 11 is plugged into one of the pluggable portions 310, the wire module 500 connected with the external power supply can automatically supply power to the single-node server 11 through the busbar 400.

The technical features in the above embodiments may be combined arbitrarily. For concise description, not all possible combinations of the technical features in the above embodiments are described. However, provided that they do not conflict with each other, all combinations of the technical features are to be considered to be within the scope described in this specification.

The above-mentioned embodiments only describe several implementations of the present disclosure, and their description is specific and detailed, but should not be understood as a limitation on the patent scope of the present disclosure. It should be noted that, for a person of ordinary skill in the art may further make variations and improvements without departing from the conception of the present disclosure, and these all fall within the protection scope of the present disclosure. Therefore, the protection scope of the present disclosure should be subject to the appended claims.

## Claims

1. A liquid cooling server cabinet (12), comprising a cabinet body (100), a liquid cooling module (200), and a pluggable assembly (300);
wherein the cabinet body (100) is provided with a receiving cavity;
the pluggable assembly (300) is arranged in the receiving cavity, and the pluggable assembly (300) comprises at least one pluggable portion (310); and
the liquid cooling module (200) comprises at least one liquid cooling unit (200a) corresponding to the at least one pluggable portion (310);
wherein the at least one pluggable portion (310) is configured for a plugging and mounting of a single-node server (11) that defines a cooling cavity, and the at least one liquid cooling unit (200a) is configured to communicate with the cooling cavity of the corresponding single-node server (11) when the single-node server (11) is mounted in the at least one pluggable portion (310).

2. The liquid cooling server cabinet (12) according to claim 1, wherein the pluggable assembly (300) further comprises a carrier plate (320), the carrier plate (320) is attached to an inner wall of the cabinet body (100), and the at least one pluggable portion (310) is arranged on a surface of the carrier plate (320).

3. The liquid cooling server cabinet (12) according to claim 1, wherein the at least one pluggable portion (310) comprises a guide rail (311) and a locking mechanism (312), and the locking mechanism (312) is arranged at an end of the guide rail (311).

4. The liquid cooling server cabinet (12) according to claim 1, wherein the liquid cooling module (200) comprises a liquid inlet module (210) and a liquid outlet module (220), the liquid inlet module (210) comprises at least one liquid inlet unit (211) corresponding to the at least one pluggable portion (310), and the liquid outlet module (220) comprises at least one liquid outlet unit (221) corresponding to the at least one pluggable portion (310).

5. The liquid cooling server cabinet (12) according to claim 4, wherein there are multiple liquid inlet units (211) and multiple liquid outlet units (221), a number of the liquid inlet units (211) is equal to a number of the liquid outlet units (221), the liquid inlet module (210) further comprises a first manifold (212) and a liquid inlet pipe (213), the liquid inlet units (211) are arranged on the first manifold (212) at equal intervals and communicated with each other via the first manifold (212), and the first manifold (212) is communicated with the liquid inlet pipe (213); and
wherein the liquid outlet module (220) further comprises a second manifold (222) and a liquid outlet pipe (223), the liquid outlet units (221) are arranged on the second manifold (222) at equal intervals and communicated with each other via the second manifold (222), and the second manifold (222) is communicated with the liquid outlet pipe (223).

6. The liquid cooling server cabinet (12) according to claim 1, further comprising a busbar (400) and a wire module (500), wherein the busbar (400) is electrically connected to the wire module (500), and the busbar (400) is configured to electrically connect to the single-node server (11) plugged and mounted in the at least one pluggable portion (310).

7. A single-node immersed server system (10), comprising a liquid cooling server cabinet (12) and at least one single-node server (11),
wherein the liquid cooling server cabinet (12) comprises a cabinet body (100), a liquid cooling module (200), and a pluggable assembly (300),
the cabinet body (100) is provided with a receiving cavity;
the pluggable assembly (300) is arranged in the receiving cavity, and the pluggable assembly (300) comprises at least one pluggable portion (310); and
the liquid cooling module (200) comprises at least one liquid cooling unit (200a) corresponding to the at least one pluggable portion (310);
wherein the at least one single-node server (11) is capable of being plugged and mounted in the at least one pluggable portion (310), the at least one single-node server (11) defines a cooling cavity, and the cooling cavity of the single-node server (11) is configured to communicate with the at least one liquid cooling unit (200a) when the at least one single-node server (11) is plugged into the at least one pluggable portion (310).

8. The single-node immersed server system (10) according to claim 7, wherein the at least one single-node server (11) is provided with a cooling liquid inlet and outlet (11a), and the cooling liquid inlet and outlet (11a) is capable of being plugged and matched with the corresponding liquid cooling unit (200a).

9. The single-node immersed server system (10) according to claim 8, wherein the single-node server (11) is further provided with a power connector (11c), and when the single-node server (11) is plugged into the at least one pluggable portion (310), the power connector (11c) is electrically connected to the liquid cooling server cabinet (12).

10. The single-node immersed server system (10) according to claim 7, wherein the pluggable assembly (300) further comprises a carrier plate (320) attached to an inner wall of the cabinet body (100), and the at least one pluggable portion (310) is arranged on a surface of the carrier plate (320).

11. The single-node immersed server system (10) according to claim 7, wherein the at least one pluggable portion (310) comprises a guide rail (311) and a locking mechanism (312), and the locking mechanism (312) is arranged at an end of the guide rail (311).

12. The single-node immersed server system (10) according to claim 11, wherein the single-node server (11) is provided with a slide bar (11b), and the slide bar (11b) is configured to slide along the guide rail (311).

13. The single-node immersed server system (10) according to claim 7, wherein the liquid cooling module (200) comprises a liquid inlet module (210) and a liquid outlet module (220), the liquid inlet module (210) comprises at least one liquid inlet unit (211) corresponding to the at least one pluggable portion (310), and the liquid outlet module (220) comprises at least one liquid outlet unit (221) corresponding to the at least one pluggable portion (310).

14. The single-node immersed server system (10) according to claim 13, wherein there are multiple liquid inlet units (211) and multiple liquid outlet units (221), a number of the liquid inlet units (211) is equal to a number of the liquid outlet units (221), the liquid inlet module (210) further comprises a first manifold (212) and a liquid inlet pipe (213), the liquid inlet units (211) are arranged on the first manifold (212) at equal intervals and communicated with each other via the first manifold (212), and the first manifold (212) is communicated with the liquid inlet pipe (213); and
wherein the liquid outlet module (220) further comprises a second manifold (222) and a liquid outlet pipe (223), the liquid outlet units (221) are arranged on the second manifold (222) at equal intervals and communicated with each other via the second manifold (222), and the second manifold (222) is communicated with the liquid outlet pipe (223).

15. The single-node immersed server system (10) according to claim 7, wherein the liquid cooling server cabinet (12) further comprises a busbar (400) and a wire module (500), the busbar (400) is electrically connected to the wire module (500), and the busbar (400) is configured to electrically connect to the single-node server (11) plugged and mounted in the at least one pluggable portion (310).

## Amended claims

### Amended claims in accordance with Rule 137(2) EPC.

1. A liquid cooling server cabinet (12), comprising a cabinet body (100), a liquid cooling module (200), and a pluggable assembly (300);
wherein the cabinet body (100) is provided with a receiving cavity;
the pluggable assembly (300) is arranged in the receiving cavity, and the pluggable assembly (300) comprises at least one pluggable portion (310); and
the liquid cooling module (200) comprises at least one liquid cooling unit (200a) corresponding to the at least one pluggable portion (310);
wherein the at least one pluggable portion (310) is configured for a plugging and mounting of a single-node server (11) that defines a cooling cavity, and the at least one liquid cooling unit (200a) is configured to communicate with the cooling cavity of the corresponding single-node server (11) when the single-node server (11) is mounted in the at least one pluggable portion (310);
wherein the liquid cooling module (200) comprises a liquid inlet module (210) and a liquid outlet module (220), the liquid inlet module (210) comprises at least one liquid inlet unit (211) and a first manifold (212), the liquid outlet module (220) comprises at least one liquid outlet unit (221) and a second manifold (222),
**characterized in that**
the first manifold (212) and the second manifold (222) are arranged parallel to each other at a preset spacing to allow a cooling liquid inlet and outlet (11a) of the single-node server (11) to automatically align with the first manifold (212) and the second manifold (222) respectively and to correspondingly communicate with the at least one liquid inlet unit (211) and the at least one liquid outlet unit (221) after the single-node server (11) is plugged into the pluggable portion (310).

2. The liquid cooling server cabinet (12) according to claim 1, wherein the pluggable assembly (300) further comprises a carrier plate (320), the carrier plate (320) is attached to an inner wall of the cabinet body (100), and the at least one pluggable portion (310) is arranged on a surface of the carrier plate (320).

3. The liquid cooling server cabinet (12) according to claim 1, wherein the at least one pluggable portion (310) comprises a guide rail (311) and a locking mechanism (312), and the locking mechanism (312) is arranged at an end of the guide rail (311).

4. The liquid cooling server cabinet (12) according to claim 1, wherein the liquid cooling module (200) comprises the liquid inlet module (210) and the liquid outlet module (220), the liquid inlet module (210) comprises the at least one liquid inlet unit (211) corresponding to the at least one pluggable portion (310), and the liquid outlet module (220) comprises the at least one liquid outlet unit (221) corresponding to the at least one pluggable portion (310).

5. The liquid cooling server cabinet (12) according to claim 4, wherein there are multiple liquid inlet units (211) and multiple liquid outlet units (221), a number of the liquid inlet units (211) is equal to a number of the liquid outlet units (221), the liquid inlet module (210) further comprises the first manifold (212) and a liquid inlet pipe (213), the liquid inlet units (211) are arranged on the first manifold (212) at equal intervals and communicated with each other via the first manifold (212), and the first manifold (212) is communicated with the liquid inlet pipe (213); and
wherein the liquid outlet module (220) further comprises the second manifold (222) and a liquid outlet pipe (223), the liquid outlet units (221) are arranged on the second manifold (222) at equal intervals and communicated with each other via the second manifold (222), and the second manifold (222) is communicated with the liquid outlet pipe (223).

6. The liquid cooling server cabinet (12) according to claim 1, further comprising a busbar (400) and a wire module (500), wherein the busbar (400) is electrically connected to the wire module (500), and the busbar (400) is configured to electrically connect to the single-node server (11) plugged and mounted in the at least one pluggable portion (310).
